# EUROPÄISCHE PATENTSCHRIFT

(11) **EP 2 760 613 B1**
(45) Veröffentlichungstag und Bekanntmachung des Hinweises auf die Patenterteilung: **08.04.2020**
(21) Anmeldenummer: 12775171.7
(22) Anmeldetag: 21.09.2012
(51) Int. Cl.: B23K 1/00, B23K 35/00, B23K 35/26, B23K 35/30, B23K 20/02, H01L 23/00, B23K 1/19, B23K 35/02, B32B 15/01, B23K 101/42

(54) **SCHICHTVERBUND AUS EINEM ELEKTRONISCHEN SUBSTRAT UND EINER SCHICHTANORDNUNG UMFASSEND EIN REAKTIONSLOT**
LAMINATED COMPOSITE MADE UP OF AN ELECTRONIC SUBSTRATE AND AN ARRANGEMENT OF LAYERS COMPRISING A REACTION SOLDER
ASSEMBLAGE STRATIFIÉ COMPOSÉ D'UN SUBSTRAT ÉLECTRONIQUE ET D'UN ENSEMBLE STRATIFIÉ COMPRENANT UN MÉTAL D'APPORT RÉACTIONNEL

(30) Priorität: 30.09.2011 DE 102011083931
(43) Veröffentlichungstag der Anmeldung: 06.08.2014
(73) Patentinhaber: Robert Bosch GmbH, 70442 Stuttgart (DE)
(72) Erfinder: GUYENOT, Michael, 71638 Ludwigsburg (DE); FEIOCK, Andrea, 72124 Pliezhausen (DE); FRUEH, Christiane, 71636 Ludwigsburg (DE); GUENTHER, Michael, 70469 Stuttgart (DE); WETZL, Franz, 74395 Mundelsheim (DE); HOHENBERGER, Bernd, 73240 Wendlingen (DE); HOLZ, Rainer, 71672 Marbach (DE); FIX, Andreas, 70439 Stuttgart (DE); KALICH, Thomas, Victoria, 3169 (AU)
(86) Internationale Anmeldenummer: PCT/EP2012/068678
(87) Internationale Veröffentlichungsnummer: WO 2013/045370

(56) Entgegenhaltungen:
- WO-A1-03/072288
- WO-A1-2010/089647
- DE-A1-102009 002 065
- DE-A1-102009 034 483
- JP-A- 2003 245 793
- US-A1- 2005 029 666
- US-A1- 2009 134 501

## Beschreibung

Die Erfindung betrifft einen Schichtverbund, enthaltend eine Schichtanordnung und ein elektronisches Substrat gemäß dem Gegenstand des Anspruchs 1 sowie eine Schaltungsanordnung, enthaltend einen Schichtverbund gemäß dem Gegenstand des Anspruchs 13. Weiterhin betrifft die Erfindung ein Verfahren zur Ausbildung eines Schichtverbunds gemäß dem Gegenstand des Anspruchs 11.

### Stand der Technik

Leistungselektronik wird in vielen Bereichen der Technik eingesetzt. Gerade in elektrischen oder elektronischen Geräten, in welchen große Ströme fließen, ist der Einsatz von Leistungselektronik unumgänglich. Die in der Leistungselektronik notwendigen Stromstärken führen zu einer thermischen Belastung der enthaltenen elektrischen oder elektronischen Komponenten. Eine weitere thermische Belastung ist gegeben durch den Einsatz derartiger elektrischer oder elektronischer Geräte an Betriebsorten mit gegenüber der Raumtemperatur deutlich erhöhter und gegebenenfalls sogar ständig wechselnder Temperatur. Als Beispiele können hierfür Steuergeräte im Automobilbereich genannt werden, welche unmittelbar im Motorraum angeordnet sind.

Insbesondere viele Anbindungen zwischen Leistungshalbleitern beziehungsweise Integrierten Schaltungen (IC, englisch: integrated circuit) untereinander sowie an Trägersubstraten, unterliegen schon heute dauerhaften Temperaturbelastungen bis 175 Grad Celsius.

Üblicherweise erfolgt eine Anbindung von elektrischen oder elektronischen Komponenten - beispielsweise auf ein Trägersubstrat - durch eine Verbindungsschicht. Als eine derartige Verbindungsschicht sind Lotverbindungen bekannt.

Zumeist werden Weichlote eingesetzt, welche Zinn-Silber- oder Zinn-Silber-Kupfer-Legierungen basieren. Besonders bei Anwendungstemperaturen nahe der Schmelztemperatur zeigen derartige Verbindungsschichten jedoch schwindende elektrische und mechanische Eigenschaften, die zu einem Ausfall der Baugruppe führen können.

Bleihaltige Lotverbindungen sind bei höheren Einsatztemperaturen einsetzbar als Weichlotverbindungen. Bleihaltige Lotverbindungen sind jedoch durch gesetzliche Bestimmungen aus Gründen des Umweltschutzes hinsichtlich ihrer zulässigen technischen Anwendungen stark beschränkt.

Alternativ bieten sich für den Einsatz bei erhöhten beziehungsweise hohen Temperaturen, insbesondere über 200 Grad Celsius, bleifreie Hartlote an. Bleifreie Hartlote weisen in der Regel einen höheren Schmelzpunkt als 200°C auf. Bei der Verwendung von Hartlot zur Ausbildung einer Verbindungsschicht kommen jedoch nur wenige elektrische oder elektronische Komponenten als Fügepartner in Frage, die den hohen Temperaturen beim Schmelzen der Hartlote standhalten können.

Einen Ausweg zeigt die Niedertemperaturverbindungstechnologie (NTV) auf, bei der silberhaltige Sinterverbindungen bei bereits wesentlich geringeren Temperaturen als der Schmelztemperatur erzeugt werden können. Anstelle eines Lots wird hierbei eine Paste eingesetzt, die chemisch stabilisierte Silberpartikel und/oder Silberverbindungen enthält. Unter den Sinterbedingungen, insbesondere unter Temperatur- und Druckbeaufschlagung, werden dabei die stabilisierenden Bestandteile ausgebrannt und/oder die Silberverbindungen aufgebrochen, so dass die Silberpartikel beziehungsweise freigesetzten Silberatome untereinander und mit dem Material der Fügepartner in direkten Kontakt kommen. Durch Interdiffusion und/oder Diffusion kann dabei bei bereits deutlich geringeren Temperaturen als der Schmelztemperatur eine hochtemperaturstabile Verbindung ausgebildet werden. Unter Temperaturwechselbeanspruchung können jedoch bei derartigen Sinterverbindungen thermomechanische Spannungen und sogar eine Rissbildung in Halbleiterbauelementen oder sogar im Trägersubstrat auftreten.

In der DE 10 2009 002 065 A1 wird ein Lot beschrieben, das ein Weichlot mit einem Schmelzpunkt von weniger als 450°C umfasst, in das eine Anzahl von Teilchen eingebettet ist, welche aus einer intermetallischen Phase gebildet oder mit einer intermetallischen Phase beschichtet sind. Das Lot kann ein metallisiertes Keramiksubstrat eines Leistungshalbleitermoduls mit einer Grundplatte flächig verbinden. Das Lot wird zur Herstellung der Lötverbindung zwischen Grundplatte und Keramiksubstrat auf eine Temperatur von wenigstens 330°C erhitzt.

In der DE 10 2009 034483 A1 ist ein Verfahren zur Herstellung einer Montage aus Nacktchip und Substrat beschrieben, das ohne bleihaltige Lotpasten auskommt und zu einer stabilen Verbindung zwischen Nacktchip und Substrat führt.

### Offenbarung der Erfindung

Gegenstand der vorliegenden Erfindung ist ein Schichtverbund umfassend mindestens ein elektronisches Substrat und eine Schichtanordnung aus zumindest einer ersten Schicht eines ersten Metalls und/oder einer ersten Metalllegierung und aus einer an diese erste Schicht angrenzenden zweiten Schicht eines zweiten Metalls und/oder einer zweiten Metalllegierung, wobei die Schmelztemperaturen der ersten und der zweiten Schicht unterschiedlich sind und wobei nach einer Temperaturbehandlung der Schichtanordnung zwischen der ersten Schicht und der zweiten Schicht ein Bereich mit mindestens einer intermetallischen Phase ausgebildet ist.

Erfindungsgemäß wird die erste oder die zweite Schicht gebildet von einem Reaktionslot, welches aus einer Mischung eines Basislots mit einer AgX-, CuX- oder NiX-Legierung besteht, wobei die Komponente X der AgX-, CuX-, oder NiX-Legierung ausgewählt ist aus der Gruppe bestehend aus B, Mg, Al, Si, Ca, Se, Ti, V, Cr, Mn, Fe, Co, Ni, Cu, Zn, Ga, Ge, Y, Zr, Nb, Mo, Ag, In, Sn, Sb, Ba, Hf, Ta, W, Au, Bi, La, Ce, Pr, Nd, Gd, Dy, Sm, Er, Tb, Eu, Ho, Tm, Yb und Lu und wobei die Schmelztemperatur der AgX-, CuX- oder NiX-Legierung größer ist als die Schmelztemperatur des Basislots.

Dabei hat die Legierung AgX, CuX, oder NiX nicht die gleiche Zusammensetzung wie die des jeweiligen Basislots. Das heißt beispielsweise, dass bei einem SnCu-Basislot keine CuSn-Partikel eingemischt sein können.

Vorteilhafterweise kann so eine elektrisch und/oder Wärme leitende Verbindung von elektronischen Bauteilen zu anderen Bauteilen oder Substraten bereit gestellt werden, die gleichzeitig einen sehr guten Ausgleich der unterschiedlichen Wärmeausdehnungskoeffizienten der Fügepartner auch über einen langen Betriebszeitraum gewährleisten kann. Dies kann unter Anderem dadurch erreicht werden, dass das Reaktionslot bei einer Temperaturbehandlung insbesondere die Bildung großer Bereiche einer intermetallischen Phase begünstigt, bis hin zum völligen Ersatz mindestens der Lotschicht durch die gebildeten Bereiche der intermetallischen Phase.

Im Rahmen einer Ausführungsform ist das Basislot ausgewählt aus der Gruppe SnCu, SnAg, SnAu, SnBi, SnNi, SnZn, Snln, Snln, CuNi, CuAg, AgBi, ZnAI, Biln, InAg, InGa, oder ternären, quarternären oder einer höherkomponentigen Legierung aus einer Mischung daraus.

Im Rahmen einer weiteren Ausführungsform liegt die AgX-, CuX- oder NiX-Legierung in einer mittleren Partikelgröße zwischen 1 nm und 50 µm in der Mischung mit dem Basislot vor.

Unter der mittleren Partikelgröße kann insbesondere die Größe verstanden werden, bei der 50 Vol.-% der Probe einen kleineren Partikeldurchmesser und 50 Vol.-% der Probe einen größeren Partikeldurchmesser aufweisen (so genannter d₅₀-Wert). Die Bestimmung der Partikelgröße kann zum Beispiel durch Laserstreuung und Auswertung der Streumuster, beispielsweise nach der Mie-Theorie, durch andere optische Analyseverfahren wie beispielsweise Mikroskopie oder durch ein Siebanalyseverfahren ermittelt werden.

Im Rahmen einer weiteren Ausführungsform enthält die erste und/oder die zweite Schicht kein Blei.
Unter der Bezeichnung "kein Blei" kann insbesondere verstanden werden, dass in der betreffenden Schicht weniger als 0,05 Gew.-% Blei enthalten ist, insbesondere weniger als 0,01 Gew.-% und beispielsweise weniger als 0,005 Gew.-%.

Die Erfindung ist damit insgesamt geeignet, eine Alternative zu bleihaltigen thermischen und elektrischen Anbindungen aufzuzeigen, zum Beispiel in der Mikroelektronik oder in der Photovoltaik, die bisher insbesondere für spezielle Einsatzgebiete beispielsweise bei hohen Temperaturen und/oder hohen Stromdichten immer noch verwendet werden.

Der Ag-, Cu- oder Ni-Anteil der von dem Reaktionslot gebildeten Schicht liegt zwischen 20 Gew-% und 80 Gew.-%.

Im Rahmen einer weiteren Ausführungsform ist die Verarbeitungstemperatur des Reaktionslots kleiner als 500 °C.

Der Gegenstand der vorliegenden Erfindung ist in der genannten Ausführungsform mithin nicht ausschließlich auf den Ersatz eines Weichlotes festgelegt sonder kann auch solche Reaktionslote umfassen, die nach der dem Fachmann geläufigen Einteilung zu den Hartloten zählen.

Gemäß einer weiteren Ausführungsform bildet die erste oder zweite Schicht, welche nicht aus dem Reaktionslot gebildet ist, mit dem Reaktionslot zumindest teilweise, bevorzugt vollständig eine intermetallische Phase aus. Gerade im Grenzbereich der ersten und der zweiten Schicht kommt es bei einer Temperaturbehandlung zu atomaren Diffusionsvorgängen, die die Ausbildung der intermetallischen Phase vom Grenzbereich aus in Richtung der ersten und/oder zweiten Phase ausbildet.

Die erste oder zweite Schicht, welche nicht aus dem Reaktionslot gebildet wird, ist eine Ag-Sinterschicht.

Vorteilhafterweise vereint eine Ag-Sinterschicht als Verbindungsschicht in der Mikroelektronik eine sehr gute Wärmeleitfähigkeit und ausgezeichnete Eigenschaften in dem Ausgleich der unterschiedlichen Wärmeausdehnungskoeffizienten der zu verbindenden elektronischen Bauteile und Substrate mit einer guten Verarbeitbarkeit.

Im Rahmen einer weiteren Ausführungsform umfasst der Bereich der intermetallischen Phase die erste oder zweite Schicht.

Auf diese Weise ist es möglich, ein nochmals verbessertes Eigenschaftsprofil der thermischen und elektrischen Anbindung eines elektronischen Substrates bereit zu stellen. Intermetallische Phasen zeigen meist aufgrund ihres hohen Ordnungsgrades eine hohe thermische und auch elektrische Leitfähigkeit. Dadurch kann vorteilhaft eine Anwendung in Geräten mit hoher Temperaturbelastung ermöglicht werden. Gleichermaßen ist eine Anwendung in Geräten möglich, die eine hohe Stromdichte auch bezüglich der Verbindungsschichten aufweisen. Zudem weisen die intermetallische Phasen gemäß der vorliegenden Erfindung meist einen geringen thermischen Ausdehnungskoeffizienten auf, was sehr vorteilhaft in einer Verbindungsschichtanordnung dazu eingesetzt werden kann, dass die Anpassung der stark unterschiedlichen Wärmeausdehnungskoeffizienten beispielsweise von einem Halbleiter eines Leistungsbauteils und von dem Material einer Wärmesenke auch dauerhaft sicher gestellt werden kann, ohne dass es zu Brüchen oder anderen Schadstellen kommt, die ein Versagen des gesamten elektronischen Bauteils hervorrufen können.

Im Rahmen einer weiteren Ausführungsform weist die intermetallische Phase einen höheren Schmelzpunkt auf als die erste oder zweite Schicht.

Hierdurch ist vorteilhafterweise ein Einsatz der elektronischen Bauteile auch in solchen Geräten möglich, die einen Einsatzort mit hoher Temperaturbelastung aufweisen wie beispielsweise Steuergeräte für Motoren oder Getriebe oder Sensoren und Dioden für Generatoren. Hier können übliche Betriebstemperaturen im Bereich von 175 °C herrschen, bei denen die elektronischen Bauteile mit einem Schichtverbund gemäß der Ausführungsform vorteilhaft eingesetzt werden können. Gleichzeitig muss jedoch die Verarbeitungstemperatur nicht so hoch gewählt werden, so dass bei der Herstellung des elektronischen Schichtverbunds eine niedrigere Temperatur eingestellt werden kann, was energiesparend, Ressourcen schonend und kostengünstig ist.

Im Rahmen einer weiteren Ausführungsform ersetzt der während der Temperaturbehandlung gebildete Bereich der intermetallischen Phase die erste und/oder zweite Schicht teilweise oder vollkommen.

Auf diese Weise ist es möglich, ein nochmals verbessertes Eigenschaftsprofil der thermischen und elektrischen Anbindung eines elektronischen Substrates bereit zu stellen. Aufgrund des hohen Ordnungsgrades zeigen intermetallische Phasen zumeist eine hohe thermische und auch elektrische Leitfähigkeit. Hierdurch kann vorteilhaft eine Anwendung in Geräten mit dauerhaft hoher Temperaturbelastung auch in Bereichen von 150 °C oder höher ermöglicht werden. Zugleich ist auch eine Anwendung in solchen Geräten ermöglicht, die eine hohe Stromdichte auch bezüglich der Verbindungsschichten aufweisen und daher eine entsprechend hohe Stromtragfähigkeit der Verbindungsschichten vorsehen. Zudem weisen die intermetallische Phasen gemäß der vorliegenden Erfindung einen geringen thermischen Ausdehnungskoeffizienten auf, was sehr vorteilhaft in einer Verbindungsschichtanordnung dazu eingesetzt werden kann, dass die Anpassung der stark unterschiedlichen Wärmeausdehnungskoeffizienten der zu verbindenden elektrischen bzw. elektronischen Komponenten, beispielsweise von einem Halbleiter eines Leistungsbauteils und von dem Material einer Wärmesenke, auch dauerhaft sicher gestellt werden kann, ohne dass es zu Brüchen oder anderen Schadstellen kommt, die ein Versagen des gesamten elektronischen Bauteils hervorrufen können.

Im Rahmen einer weiteren Ausführungsform kontaktiert die erste und/oder zweite Schicht das mindestens eine elektronische Substrat.

Auf diese Weise ist es erfindungsgemäß auch möglich, ein Halbzeug in der mikroelektronischen Industrie bereit zu stellen, wobei das elektronische Substrat entweder mit der ersten Schicht, beispielsweise mit einer Silbersinterschicht, oder mit der zweiten Schicht, beispielsweise mit der aus dem Reaktionslot gebildeten Schicht, welche auch vollständig durch eine intermetallische Phase ersetzt sein kann, kontaktiert ist. Hierdurch können sowohl Automatisierungsgrade in der Fertigung erhöht werden als auch die Einhaltung von vorher festgelegten Qualitätsstandards und Toleranzen verbessert werden.

Im Rahmen einer weiteren Ausführungsform ist diejenige Schicht, die durch das Reaktionslot gebildet wird, bereits vor der Anbindung an das mindestens eine Substrat in der anderen Schicht, welche bevorzugt durch eine Ag-Sinterschicht gebildet ist, infiltriert.

Unter dem Begriff "infiltriert" kann insbesondere verstanden werden, dass das Reaktionslot mindestens teilweise in den in der Ag-Sinterschicht vorhandenen Poren, oder in vergleichbaren Zwischenräumen in der anderen Schicht, angeordnet ist. Durch die Temperaturbehandlung kann zwischen den Schichten mindestens teilweise eine intermetallische Phase ausgebildet werden. Dieser Vorgang der Ausbildung einer intermetallischen Phase, insbesondere durch Interdiffusion der Metalle bzw. der Legierungen der beiden Schichten, kann durch die vorherige Infiltration des Reaktionslots in der anderen Schicht vereinfacht und vervollständigt werden, so dass eine kürzere Temperaturbehandlung beziehungsweise die Ausbildung größerer Bereiche der intermetallischen Phase ermöglicht wird verglichen mit einer reinen nur angrenzenden Anordnung der Schichten.
Zur Optimierung der Infiltration wird insbesondere die durchschnittliche Partikelgröße der AgX-, CuX- oder NiX-Legierung des Reaktionslots vorteilhaft an die Porengröße beziehungsweise an die Größe der vorhandenen Zwischenräume in der anderen, zu infiltrierenden Schicht angepasst.

Mit anderen Worten kann die Schichtanordnung der vorliegenden Erfindung auch in der Weise ausgebildet sein, dass die das Reaktionslot umfassende Schicht zumindest teilweise, bevorzugt vollständig, in einer porösen oder andere Zwischenräume oder Kammern aufweisenden anderen Schicht infiltriert vorliegt.

Im Rahmen einer weiteren Ausführungsform ist das mindestens eine elektronische Substrat ein Schaltungsträger, insbesondere ein DBC-Substrat, ein LTCC-Substrat, ein Stanzgitter, eine Leiterplatte oder ein aktives Bauelement, insbesondere ein Leistungshalbleiter oder IC, oder ein Trägersubstrat oder eine Wärmesenke.

Hinsichtlich weiterer Vorteile und Merkmale wird hiermit explizit auf die Erläuterungen im Zusammenhang mit dem erfindungsgemäßen Schichtverbund, dem Produkt des erfindungsgemäßen Verfahrens, der erfindungsgemäßen Schaltungsanordnung sowie den Figuren verwiesen.

Ein weiterer Gegenstand der vorliegenden Erfindung ist ein Verfahren zur Ausbildung eines Schichtverbunds, insbesondere eines erfindungsgemäßen Schichtverbunds, umfassend folgende Schritte:
- Ausbilden eines Rohschichtverbunds enthaltend eine Schichtanordnung und mindestens ein elektronisches Substrat, wobei die Schichtanordnung mindestens eine erste Schicht eines ersten Metalls und/oder einer ersten Metalllegierung und eine an diese erste Schicht angrenzende zweite Schicht eines zweiten Metalls und/oder einer zweiten Metalllegierung enthält und wobei die Schmelztemperaturen der ersten und der zweiten Schicht unterschiedlich sind, und wobei die erste oder die zweite Schicht gebildet wird von einem Reaktionslot, welches aus einer Mischung eines Basislots mit einer AgX-, CuX- oder NiX-Legierung besteht, wobei die Schmelztemperatur der AgX-, CuX- oder NiX-Legierung größer ist als die Schmelztemperatur des Basislots,
- Temperaturbehandeln der Schichtanordnung oder des Rohschichtverbunds, wodurch eine Interdiffusion der Metalle und/oder Metalllegierungen in der ersten und/oder zweiten Schicht erfolgt,
- Ausbilden des Schichtverbunds enthaltend zumindest einen Bereich einer intermetallischen Phase zwischen der ersten und der zweiten Schicht.

Im Rahmen einer Ausführungsform des erfindungsgemäßen Verfahrens wird die Temperaturbehandlung bei einer Temperatur oberhalb der Schmelztemperatur des Basislots im Reaktionslot durchgeführt.

Hierdurch wird bevorzugt sicher gestellt, dass ein möglichst großer Bereich einer intermetallischen Phase aus dem Reaktionslot und der anderen Schicht gebildet wird, so dass die vorstehend bereits beschriebenen Vorteile im Eigenschaftsprofil der elektrischen und thermischen Anbindung des elektronischen Substrats optimal erreicht werden können.

Ein weiterer Gegenstand der vorliegenden Erfindung ist eine Schaltungsanordnung enthaltend einen Schichtverbund gemäß der vorstehend beschrieben Erfindung, insbesondere für elektronische Schaltungsanordnungen für die Automobilserienproduktion und die Photovoltaikindustrie.

### Zeichnungen

Weitere Vorteile und vorteilhafte Ausgestaltungen der erfindungsgemäßen Gegenstände werden durch die Zeichnungen veranschaulicht und in der nachfolgenden Beschreibung erläutert. Dabei ist zu beachten, dass die Zeichnungen nur beschreibenden Charakter haben und nicht dazu gedacht sind, die Erfindung in irgendeiner Form einzuschränken. Es zeigen
- Fig. 1: einen schematischen Querschnitt durch einen erfindungsgemäßen Schichtverbund und
- Fig. 2: einen schematischen Querschnitt durch einen Rohschichtverbund.

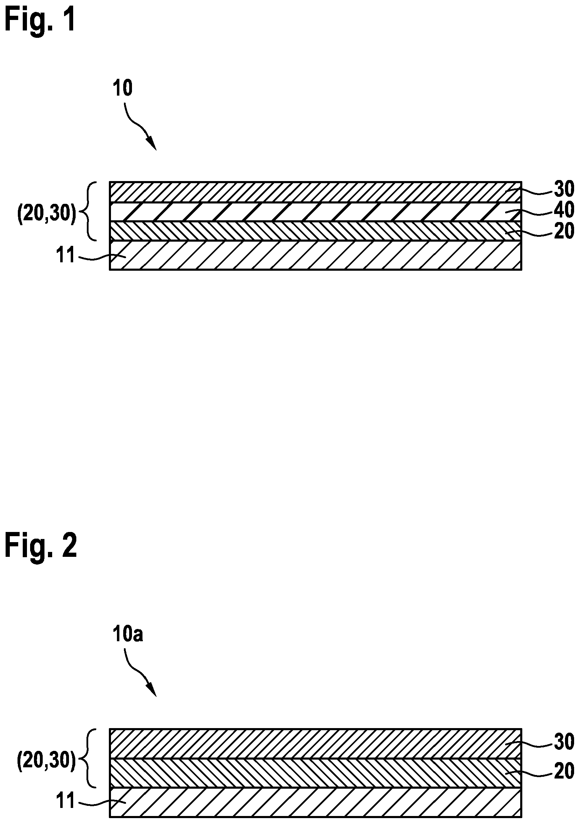

Fig. 1 zeigt einen Schichtverbund 10 umfassend mindestens ein elektronisches Substrat 11 und eine Schichtanordnung 20, 30 aus zumindest einer ersten Schicht 20 eines ersten Metalls und/oder einer ersten Metalllegierung und aus einer an diese erste Schicht angrenzenden zweiten Schicht 30 eines zweiten Metalls und/oder einer zweiten Metalllegierung. Die Schmelztemperaturen der ersten Schicht 20 und der zweiten Schicht 30 sind unterschiedlich. Durch eine Temperaturbehandlung ist zwischen der ersten Schicht und der zweiten Schicht ein Bereich 40 mit mindestens einer intermetallischen Phase ausgebildet. Die erste oder die zweite Schicht kann von einem Reaktionslot gebildet werden, welches aus einer Mischung eines Basislots mit einer AgX-, CuX- oder NiX-Legierung besteht. Die AgX-, CuX- oder NiX-Legierung ist dabei so ausgewählt, dass ihre Schmelztemperatur größer ist als die Schmelztemperatur des Basislots. Die mittlere Partikelgröße der AgX-, CuX- oder NiX-Legierung kann zwischen 1 nm bis 50 µm liegen. Die im Bereich 40 gebildete intermetallische Phase kann einen höheren Schmelzpunkt aufweisen als die erste oder zweite Schicht 20, 30. Hierdurch ist vorteilhafterweise ein Einsatz der elektronischen Bauteile auch in solchen Geräten möglich, die einen Einsatzort mit hoher Temperaturbelastung aufweisen. In der gezeigten Ausführungsform ersetzt der während einer Temperaturbehandlung gebildete Bereich 40 der intermetallischen Phase die erste und/oder zweite Schicht 20, 30 jeweils teilweise. Es ist auch möglich, dass der Bereich 40 der intermetallischen Phase die Schichten 20 und 30 vollständig ersetzt. Vorteilhafterweise kann mit dem Schichtverbund 20, 30 eine elektrisch und/oder Wärme leitende Verbindung von elektronischen Bauteilen zu anderen Bauteilen oder Substraten bereit gestellt werden, die gleichzeitig einen sehr guten Ausgleich der unterschiedlichen Wärmeausdehnungskoeffizienten der Fügepartner auch über einen langen Betriebszeitraum gewährleisten kann.

Fig. 2 zeigt einen Rohschichtverbund 10a umfassend mindestens ein elektronisches Substrat 11 und eine Schichtanordnung 20, 30 aus zumindest einer ersten Schicht 20 eines ersten Metalls und/oder einer ersten Metalllegierung und aus einer an diese erste Schicht angrenzenden zweiten Schicht 30 eines zweiten Metalls und/oder einer zweiten Metalllegierung. Durch eine Temperaturbehandlung des Rohschichtverbunds 10a kann eine Interdiffusion der Metalle und/oder Metalllegierungen in der ersten und/oder zweiten Schicht erfolgen und so zwischen der ersten Schicht und der zweiten Schicht ein Bereich 40 mit mindestens einer intermetallischen Phase ausgebildet und der in Figur 1 gezeigte Schichtverbund 10 hergestellt werden. Die Temperaturbehandlung des Rohschichtverbunds 10a kann beispielsweise bei einer Temperatur oberhalb der Schmelztemperatur des Basislots im Reaktionslot durchgeführt werden.

## Patentansprüche

1. Schichtverbund (10) umfassend mindestens ein elektronisches Substrat (11) und eine Schichtanordnung (20, 30) aus zumindest einer ersten Schicht eines ersten Metalls und/oder einer ersten Metalllegierung und aus einer an diese erste Schicht angrenzenden zweiten Schicht eines zweiten Metalls und/oder einer zweiten Metalllegierung, wobei die Schmelztemperaturen der ersten und der zweiten Schicht unterschiedlich sind,
**dadurch gekennzeichnet, dass**
nach einer Temperaturbehandlung der Schichtanordnung (20, 30) zwischen der ersten Schicht und der zweiten Schicht ein Bereich mit mindestens einer intermetallischen Phase (40) ausgebildet ist, wobei die erste oder die zweite Schicht gebildet wird von einem Reaktionslot, welches aus einer Mischung eines Basislots mit einer AgX-, CuX- oder NiX-Legierung besteht und der Ag-, Cu- oder Ni-Anteil der von dem Reaktionslot gebildeten Schicht zwischen 20 Gew-% und 80 Gew.-% liegt, wobei die Komponente X der AgX-, CuX-, oder NiX-Legierung ausgewählt ist aus der Gruppe bestehend aus B, Mg, AI, Si, Ca, Se, Ti, V, Cr, Mn, Fe, Co, Ni, Cu, Zn, Ga, Ge, Y, Zr, Nb, Mo, Ag, In, Sn, Sb, Ba, Hf, Ta, W, Au, Bi, La, Ce, Pr, Nd, Gd, Dy, Sm, Er, Tb, Eu, Ho, Tm, Yb und Lu, wobei die Ag-X, CuX- oder NiX-Legierung nicht die gleichen Zusammensetzung wie die des jeweiligen Basislots haben, und wobei die Schmelztemperatur der AgX-, CuX- oder NiX-Legierung größer ist als die Schmelztemperatur des Basislots, und die die erste (20) oder zweite Schicht (30), welche nicht aus dem Reaktionslot gebildet wird, eine Ag-Sinterschicht ist.

2. Schichtverbund (10) nach Anspruch 1 **dadurch gekennzeichnet, dass** das Basislot ausgewählt ist aus der Gruppe SnCu, SnAg, SnAu, SnBi, SnNi, SnZn, Snln, Snln, CuNi, CuAg, AgBi, ZnAI, Biln, InAg, InGa, oder ternären, quarternären oder einer höherkomponentigen Legierung aus einer Mischung daraus.

3. Schichtverbund (10) nach einem der Ansprüche 1 oder 2, **dadurch gekennzeichnet, dass** die AgX-, CuX- oder NiX-Legierung in einer mittleren Partikelgröße zwischen 1 nm und 50 µm in der Mischung mit dem Basislot vorliegt.

4. Schichtverbund (10) nach einem der Ansprüche 1, 2 oder 3, **dadurch gekennzeichnet, dass** die erste (20) oder die zweite Schicht (30) kein Blei enthält.

5. Schichtverbund (10) nach einem der vorherigen Ansprüche, **dadurch gekennzeichnet, dass** die Verarbeitungstemperatur des Reaktionslots kleiner ist als 500 °C.

6. Schichtverbund (10) nach einem der vorherigen Ansprüche, **dadurch gekennzeichnet, dass** der Bereich der intermetallischen Phase (40) die erste (20) oder zweite Schicht (30) umfasst.

7. Schichtverbund (10) nach einem der vorherigen Ansprüche, **dadurch gekennzeichnet, dass** die intermetallische Phase (40) einen höheren Schmelzpunkt aufweist als die erste oder zweite Schicht.

8. Schichtverbund (10) nach einem der vorherigen Ansprüche, **dadurch gekennzeichnet, dass** der während der Temperaturbehandlung gebildete Bereich der intermetallischen Phase (40) die erste (20) und/oder zweite Schicht (30) teilweise oder vollkommen ersetzt.

9. Schichtverbund (10) nach einem der vorherigen Ansprüche, **dadurch gekennzeichnet, dass** die erste (20) und/oder zweite Schicht (30) das mindestens eine elektronische Substrat (11) kontaktiert.

10. Schichtverbund (10) nach einem der vorherigen Ansprüche, **dadurch gekennzeichnet, dass** das mindestens eine elektronische Substrat (11) ein Schaltungsträger oder ein aktives Bauelement oder ein Trägersubstrat oder eine Wärmesenke ist.

11. Verfahren zur Ausbildung eines Schichtverbunds (10) nach einem der vorherigen Ansprüche 1 bis 10, umfassend folgende Schritte:
- Ausbilden eines Rohschichtverbunds (10a) enthaltend eine Schichtanordnung (20, 30) und mindestens ein elektronisches Substrat (11), wobei die Schichtanordnung (20, 30) mindestens eine erste Schicht (20) eines ersten Metalls und/oder einer ersten Metalllegierung und eine an diese erste Schicht angrenzende zweite Schicht (30) eines zweiten Metalls und/oder einer zweiten Metalllegierung enthält und wobei die Schmelztemperaturen der ersten (20) und der zweiten Schicht (30) unterschiedlich sind, und wobei die erste (20) oder die zweite Schicht (30) gebildet wird von einem Reaktionslot, welches aus einer Mischung eines Basislots mit einer AgX-, CuX- oder NiX-Legierung besteht und der Ag-, Cu- oder Ni-Anteil der von dem Reaktionslot gebildeten Schicht zwischen 20 Gew-% und 80 Gew.-% liegt, wobei die Komponente X der AgX-, CuX-, oder NiX-Legierung ausgewählt ist aus der Gruppe bestehend aus B, Mg, Al, Si, Ca, Se, Ti, V, Cr, Mn, Fe, Co, Ni, Cu, Zn, Ga, Ge, Y, Zr, Nb, Mo, Ag, In, Sn, Sb, Ba, Hf, Ta, W, Au, Bi, La, Ce, Pr, Nd, Gd, Dy, Sm, Er, Tb, Eu, Ho, Tm, Yb und Lu, wobei die Ag-X, CuX- oder NiX-Legierung nicht die gleichen Zusammensetzung wie die des jeweiligen Basislots haben, wobei die Schmelztemperatur der AgX-, CuX- oder NiX-Legierung größer ist als die Schmelztemperatur des Basislots,
- Temperaturbehandeln der Schichtanordnung (20, 30) oder des Rohschichtverbunds (10a), wodurch eine Interdiffusion der Metalle und/oder Metalllegierungen in der ersten (20) und/oder zweiten Schicht (30) erfolgt,
- Ausbilden des Schichtverbunds (10) enthaltend zumindest einen Bereich einer intermetallischen Phase (40) zwischen der ersten und der zweiten Schicht.

12. Verfahren nach Anspruch 11, **dadurch gekennzeichnet, dass** die Temperaturbehandlung bei einer Temperatur oberhalb der Schmelztemperatur des Basislots im Reaktionslot durchgeführt wird.

13. Schaltungsanordnung enthaltend einen Schichtverbund (10) gemäß einem der Ansprüche 1 bis 10.

## Claims

1. Laminated composite (10) comprising at least one electronic substrate (11) and a layer arrangement (20, 30) made up of at least a first layer of a first metal and/or a first metal alloy and made up of a second layer, adjoining said first layer, of a second metal and/or a second metal alloy, wherein the melting temperatures of the first layer and of the second layer are different, **characterized in that**, after the layer arrangement (20, 30) has been subjected to a thermal treatment, a region with at least one intermetallic phase (40) is formed between the first layer and the second layer, wherein the first layer or the second layer is formed by a reaction solder which consists of a mixture of a base solder with an AgX, CuX or NiX alloy and the Ag, Cu or Ni content of the layer formed by the reaction solder is between 20% by weight and 80% by weight, wherein the component X in the AgX, CuX or NiX alloy is selected from the group consisting of B, Mg, Al, Si, Ca, Se, Ti, V, Cr, Mn, Fe, Co, Ni, Cu, Zn, Ga, Ge, Y, Zr, Nb, Mo, Ag, In, Sn, Sb, Ba, Hf, Ta, W, Au, Bi, La, Ce, Pr, Nd, Gd, Dy, Sm, Er, Tb, Eu, Ho, Tm, Yb and Lu, wherein the Ag-X, CuX or NiX alloy do not have the same composition as that of the respective base solder, and wherein the melting temperature of the AgX, CuX or NiX alloy is higher than the melting temperature of the base solder, and the first layer (20) or second layer (30) which is not formed from the reaction solder is an Ag sintered layer.

2. Laminated composite (10) according to Claim 1, **characterized in that** the base solder is selected from the group consisting of SnCu, SnAg, SnAu, SnBi, SnNi, SnZn, SnIn, SnIn, CuNi, CuAg, AgBi, ZnAl, BiIn, InAg, InGa or a ternary, quaternary or a higher-component alloy made up of a mixture thereof.

3. Laminated composite (10) according to either of Claims 1 and 2, **characterized in that** the AgX, CuX or NiX alloy is present in a mean particle size of between 1 nm and 50 µm in the mixture with the base solder.

4. Laminated composite (10) according to one of Claims 1, 2 or 3, **characterized in that** the first layer (20) or the second layer (30) contains no lead.

5. Laminated composite (10) according to one of the preceding claims, **characterized in that** the processing temperature of the reaction solder is less than 500°C.

6. Laminated composite (10) according to one of the preceding claims, **characterized in that** the region of the intermetallic phase (40) encompasses the first layer (20) or second layer (30).

7. Laminated composite (10) according to one of the preceding claims, **characterized in that** the intermetallic phase (40) has a higher melting point than the first or second layer.

8. Laminated composite (10) according to one of the preceding claims, **characterized in that** the region of the intermetallic phase (40) which is formed during the thermal treatment partially or completely replaces the first layer (20) and/or second layer (30).

9. Laminated composite (10) according to one of the preceding claims, **characterized in that** the first layer (20) and/or second layer (30) makes contact with the at least one electronic substrate (11).

10. Laminated composite (10) according to one of the preceding claims, **characterized in that** the at least one electronic substrate (11) is a circuit carrier, or an active component, or a carrier substrate or a heat sink.

11. Method for forming a laminated composite (10), according to one of the preceding Claims 1 to 10, comprising the following steps:
- forming a raw laminated composite (10a) containing a layer arrangement (20, 30) and at least one electronic substrate (11), wherein the layer arrangement (20, 30) contains at least a first layer (20) of a first metal and/or a first metal alloy and a second layer (30), adjoining said first layer, of a second metal and/or a second metal alloy, and wherein the melting temperatures of the first layer (20) and of the second layer (30) are different, and wherein the first layer (20) or the second layer (30) is formed by a reaction solder which consists of a mixture of a base solder with an AgX, CuX or NiX alloy and the Ag, Cu or Ni content of the layer formed by the reaction solder is between 20% by weight and 80% by weight, wherein the component X in the AgX, CuX or NiX alloy is selected from the group consisting of B, Mg, Al, Si, Ca, Se, Ti, V, Cr, Mn, Fe, Co, Ni, Cu, Zn, Ga, Ge, Y, Zr, Nb, Mo, Ag, In, Sn, Sb, Ba, Hf, Ta, W, Au, Bi, La, Ce, Pr, Nd, Gd, Dy, Sm, Er, Tb, Eu, Ho, Tm, Yb and Lu, wherein the Ag-X, CuX or NiX alloy do not have the same composition as that of the respective base solder, and wherein the melting temperature of the AgX, CuX or NiX alloy is higher than the melting temperature of the base solder,
- subjecting the layer arrangement (20, 30) or the raw laminated composite (10a) to thermal treatment, as a result of which interdiffusion of the metals and/or metal alloys in the first layer (20) and/or second layer (30) takes place,
- forming the laminated composite (10) containing at least one region of an intermetallic phase (40) between the first layer and the second layer.

12. Method according to Claim 11, **characterized in that** the thermal treatment is carried out at a temperature above the melting temperature of the base solder in the reaction solder.

13. Circuit arrangement containing a laminated composite (10) according to one of Claims 1 to 10.

## Revendications

1. Composite de couches (10) comprenant au moins un substrat électronique (11) et un agencement de couches (20, 30) d'au moins une première couche d'un premier métal et/ou d'un premier alliage métallique et d'une deuxième couche d'un deuxième métal et/ou d'un deuxième alliage métallique adjacente à cette première couche, les températures de fusion de la première et de la deuxième couche étant différentes,
**caractérisé en ce que**
après un traitement thermique de l'agencement de couches (20, 30), une zone contenant au moins une phase intermétallique (40) est formée entre la première couche et la deuxième couche, la première ou la deuxième couche étant formée par un métal d'apport réactif, qui est constitué par un mélange d'un métal d'apport de base avec un alliage d'AgX, de CuX ou de NiX, et la proportion d'Ag, de Cu ou de Ni de la couche formée par le métal d'apport réactif étant comprise entre 20 % en poids et 80 % en poids, le composant X de l'alliage d'AgX, de CuX ou de NiX étant choisi dans le groupe constitué par B, Mg, Al, Si, Ca, Se, Ti, V, Cr, Mn, Fe, Co, Ni, Cu, Zn, Ga, Ge, Y, Zr, Nb, Mo, Ag, In, Sn, Sb, Ba, Hf, Ta, W, Au, Bi, La, Ce, Pr, Nd, Gd, Dy, Sm, Er, Tb, Eu, Ho, Tm, Yb et Lu, l'alliage d'AgX, de CuX ou de NiX n'ayant pas la même composition que celle du métal d'apport de base respectif, et la température de fusion de l'alliage d'AgX, de CuX ou de NiX étant supérieure à la température de fusion du métal d'apport de base, et la première (20) ou la deuxième couche (30), qui n'est pas formée par le métal d'apport réactif, étant une couche frittée d'Ag.

2. Composite de couches (10) selon la revendication 1, **caractérisé en ce que** le métal d'apport de base est choisi dans le groupe constitué par SnCu, SnAg, SnAu, SnBi, SnNi, SnZn, SnIn, SnIn, CuNi, CuAg, AgBi, ZnAl, BiIn, InAg, InGa, ou un alliage ternaire, quaternaire ou à nombre de composants plus élevé d'un mélange de ceux-ci.

3. Composite de couches (10) selon l'une quelconque des revendications 1 ou 2, **caractérisé en ce que** l'alliage d'AgX, de CuX ou de NiX se présente en une taille de particule moyenne comprise entre 1 nm et 50 µm dans le mélange avec le métal d'apport de base.

4. Composite de couches (10) selon l'une quelconque des revendications 1, 2 ou 3, **caractérisé en ce que** la première (20) ou la deuxième couche (30) ne contient pas de plomb.

5. Composite de couches (10) selon l'une quelconque des revendications précédentes, **caractérisé en ce que** la température d'usinage du métal d'apport réactif est inférieure à 500 °C.

6. Composite de couches (10) selon l'une quelconque des revendications précédentes, **caractérisé en ce que** la zone de la phase intermétallique (40) comprend la première (20) ou la deuxième couche (30).

7. Composite de couches (10) selon l'une quelconque des revendications précédentes, **caractérisé en ce que** la phase intermétallique (40) présente un point de fusion plus élevé que la première ou la deuxième couche.

8. Composite de couches (10) selon l'une quelconque des revendications précédentes, **caractérisé en ce que** la zone de la phase intermétallique (40) formée pendant le traitement thermique remplace en partie ou en totalité la première (20) et/ou la deuxième couche (30) .

9. Composite de couches (10) selon l'une quelconque des revendications précédentes, **caractérisé en ce que** la première (20) et/ou la deuxième couche (30) rentre en contact avec ledit au moins un substrat électronique (11) .

10. Composite de couches (10) selon l'une quelconque des revendications précédentes, **caractérisé en ce que** ledit au moins un substrat électronique (11) est un support de circuit ou un composant actif ou un substrat support ou un puits de chaleur.

11. Procédé de formation d'un composite de couches (10) selon l'une quelconque des revendications 1 à 10 précédentes, comprenant les étapes suivantes :
- la formation d'un composite de couches brut (10a) contenant un agencement de couches (20, 30) et au moins un substrat électronique (11), l'agencement de couches (20, 30) contenant au moins une première couche (20) d'un premier métal et/ou d'un premier alliage métallique et une deuxième couche (30) d'un deuxième métal et/ou d'un deuxième alliage métallique adjacente à cette première couche, et les températures de fusion de la première (20) et de la deuxième couche (30) étant différentes, et la première (20) ou la deuxième couche (30) étant formée par un métal d'apport réactif, qui est constitué par un mélange d'un métal d'apport de base avec un alliage d'AgX, de CuX ou de NiX, et la proportion d'Ag, de Cu ou de Ni de la couche formée par le métal d'apport réactif étant comprise entre 20 % en poids et 80 % en poids, le composant X de l'alliage d'AgX, de CuX ou de NiX étant choisi dans le groupe constitué par B, Mg, Al, Si, Ca, Se, Ti, V, Cr, Mn, Fe, Co, Ni, Cu, Zn, Ga, Ge, Y, Zr, Nb, Mo, Ag, In, Sn, Sb, Ba, Hf, Ta, W, Au, Bi, La, Ce, Pr, Nd, Gd, Dy, Sm, Er, Tb, Eu, Ho, Tm, Yb et Lu, l'alliage d'Ag-X, de CuX ou de NiX n'ayant pas la même composition que celle du métal d'apport de base respectif, la température de fusion de l'alliage d'AgX, de CuX ou de NiX étant supérieure à la température de fusion du métal d'apport de base,
- le traitement thermique de l'agencement de couches (20, 30) ou du composite de couches brut (10a), ce qui permet une interdiffusion des métaux et/ou alliages métalliques dans la première (20) et/ou deuxième couche (30),
- la formation du composite de couches (10) contenant au moins une zone d'une phase intermétallique (40) entre la première et la deuxième couche.

12. Procédé selon la revendication 11, **caractérisé en ce que** le traitement thermique est réalisé à une température supérieure à la température de fusion du métal d'apport de base dans le métal d'apport réactif.

13. Agencement de circuit contenant un composite de couches (10) selon l'une quelconque des revendications 1 à 10.
